(19) Europäisches Patentamt
European Patent Office
Office européen des brevets

(11) **EP 3 997 465 B1**

(12) **EUROPEAN PATENT SPECIFICATION**

(45) Date of publication and mention
of the grant of the patent:
**03.09.2025 Bulletin 2025/36**

(21) Application number: **19937338.2**

(22) Date of filing: **10.07.2019**

(51) International Patent Classification (IPC):
*G01R 19/00* (2006.01)    *G01R 15/18* (2006.01)
*G01R 19/04* (2006.01)    *G01R 19/25* (2006.01)

(52) Cooperative Patent Classification (CPC):
**G01R 15/18; G01R 19/25;** G01R 19/04

(86) International application number:
**PCT/CN2019/095490**

(87) International publication number:
**WO 2021/003719 (14.01.2021 Gazette 2021/02)**

(54) **SENSING APPARATUS AND SENSING METHOD**

SENSORVORRICHTUNG UND SENSORVERFAHREN

APPAREIL DE DÉTECTION ET PROCÉDÉ DE DÉTECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.05.2022 Bulletin 2022/20**

(73) Proprietor: **ABB SCHWEIZ AG**
**5400 Baden (CH)**

(72) Inventors:
• ZHUANG, Zhijian
Xiamen, Fujian 361021 (CN)
• LU, Congwen
Xiamen, Fujian 361006 (CN)
• YE, Xin
Xiamen, Fujian 361006 (CN)

(74) Representative: **Zimmermann & Partner
Patentanwälte mbB
Postfach 330 920
80069 München (DE)**

(56) References cited:
WO-A2-2008/008446    CN-A- 1 542 456
CN-A- 105 067 906    CN-A- 106 842 099
CN-A- 108 288 345    CN-A- 108 594 155
CN-A- 108 988 628    JP-A- H0 413 978
JP-A- H0 413 978    US-A- 6 040 689
US-A1- 2003 062 887    US-A1- 2005 013 077
US-B2- 7 869 169

## Description

### FIELD

Embodiments of the present disclosure relate to a sensing apparatus and a sensing method.

### BACKGROUND

Switchgears are widely utilized in electrical power systems. In order to ensure normal functions of the switchgear for the electrical power system, it is important to monitor operating parameters of the switchgear. WO2008008446A2 describes a circuit breaker having a current transformer for powering trip unit electronics and sensing low and high currents includes a core with solid and gapped laminations. US6040689A describes a current transformer producing a secondary current is disposed in communication with a conductor having a primary current desired to be sensed. Some solutions for sensing a temperature of the switchgear have been proposed in the art. For example, Patent Publication CN203405292U describes a solution for sensing a temperature of a contact arm for a circuit breaker in the switchgear by a temperature sensor embedded in the contact arm, thereby monitoring a temperature condition of the switchgear.

Actually, a real-time current of the switchgear is highly correlated with the temperature of the switchgear. If only the temperature is measured without considering the real-time current, such as a current load, a potential failure cannot be detected in advance until the current load comes closely to a rated current load. Some solutions for sensing the real-time current of the switchgear have also been proposed in the art. For example, Patent Publication CN103854446B describes a solution for sensing the real-time current of the switchgear by a current sensor while monitoring the temperature of the switchgear by a temperature sensor.

However, in such a solution, the additional current sensor is required to be mounted into the switchgear to measure the real-time current. It is desirable to provide an improved solution for measuring the real-time current while monitoring the temperature.

### SUMMARY

Embodiments of the present disclosure are directed to a sensing apparatus and a sensing method which allow measuring the real-time current while monitoring the temperature by an integrated sensing module.

In a first aspect, embodiments of the present disclosure provide a sensing apparatus. The sensing apparatus comprises: a current sensing circuit configured to sense a secondary current generated from a current transformer to generate a secondary current signal representing the secondary current, wherein the current transformer is configured to receive a primary current from a bus bar to generate the secondary current for supplying a power to the sensing apparatus; and a controller configured to detect a peak value of the secondary current signal during a saturation of the current transformer, and configured to measure the primary current based on the peak value of the secondary current signal by a look-up table.

Compared with the conventional solutions, the sensing apparatus according to embodiments of the present disclosure allows the current sensing module to be integrated with the temperature sensing module, thereby omitting an additional current sensor in a solution of monitoring the temperature while considering the current, and simplifying the structure for the integrated sensing module and facilitating the assembly for the sensing module.

In some embodiments, the controller is configured to measure the primary current by searching the look-up table with the peak value of the secondary current signal, the look-up table storing values of the primary current and respective peak values of the secondary current signal.

In some embodiments, the values of the primary current are associated with the respective peak values of the secondary current signal by a fitting curve.

In some embodiments, the fitting curve is represented by at least one of the following: an exponential function, a Fourier function, a Gauss function, a sine function, a power function, or a polynomial function.

In some embodiments, the sensing apparatus further comprises: a temperature sensor configured to measure a temperature.

In some embodiments, the temperature sensor is configured to measure the temperature of a contact arm of the switchgear electrically coupled to the bus bar.

In some embodiments, the temperature sensor is supplied with the power.

In some embodiments, the sensing apparatus further comprises: a rectifying circuit configured to rectify the secondary current to generate a rectified secondary current; and a voltage regulating circuit configured to generate a first regulated voltage based on the rectified secondary current to supply a first power to the temperature sensor.

In some embodiments, the voltage regulating circuit is further configured to generate a second regulated voltage based on the rectified secondary current to supply a second power to the controller.

In some embodiments, the current sensing circuit is configured to sense the rectified secondary current to generate the secondary current signal.

In some embodiments, the sensing apparatus further comprises the current transformer.

In some embodiments, the sensing apparatus further comprises: a circuit board on which the current sensing circuit and the controller are mounted; and a signal line electrically coupling the circuit board to the current transformer.

In some embodiments, the sensing apparatus further comprises: a circuit board on which the current sensing circuit, the controller, the rectifying circuit and the voltage regulating circuit are mounted; and a signal line electrically coupling the circuit board to the current transformer.

In a second aspect, embodiments of the present disclosure provide a smart arm for the switchgear. The smart arm comprises: a contact arm configured to be electrically coupled to a bus bar; and the sensing apparatus as mentioned above.

In some embodiments, the sensing apparatus is embedded within the contact arm or mounted onto an outer surface of the contact arm.

In some embodiments, the current transformer is electrically coupled to the contact arm.

In a third aspect, embodiments of the present disclosure provide a sensing method. The sensing method comprises: receiving a secondary current signal representing a secondary current that is generated by a current transformer from a primary current; detecting a peak value of the secondary current signal during a saturation of the current transformer; and measuring the primary current based on the peak value of the secondary current signal by a look-up table.

In some embodiments, measuring the primary current comprises: measuring the primary current by searching the look-up table with the peak value of the secondary current signal, the look-up table storing values of the primary current and respective peak values of the secondary current signal.

In some embodiments, the values of the primary current are associated with the respective peak values of the secondary current signal by a fitting curve.

In some embodiments, the fitting curve is represented by at least one of the following: an exponential function, a Fourier function, a Gauss function, a sine function, a power function, or a polynomial function.

According to embodiments of the present disclosure, the peak value for the secondary current of the current transformer is detected during the saturation of the current transformer to obtain the corresponding value of the primary current of the current transformer. In this way, the temperature sensing and the primary current sensing can be implemented by a signal integrated sensing module without configuring an additional current sensor for the primary current at the bus bar.

## BRIEF DESCRIPTION OF THE DRAWINGS

Embodiments are shown and illustrated with reference to the drawings. The drawings serve to illustrate the basic principle, so that only aspects necessary for understanding the basic principle are illustrated. The drawings are not to scale. For a more complete understanding of the present invention, and the advantages thereof, reference is now made to the following descriptions taken in conjunction with the accompanying drawings, in which:

Fig. 1A illustrates a graph for monitoring a temperature of a contact arm without considering a current flowing through the contact arm;

Fig. 1B illustrates a graph for monitoring a temperature of a contact arm while considering a current flowing through the contact arm;

Fig. 2 illustrates a block diagram of a sensing apparatus according to an embodiment of the present disclosure;

Fig. 3 illustrates an equivalent circuit diagram of a current transformer according to an embodiment of the present disclosure;

Fig. 4 illustrates a graph showing a relationship between an output of a current transformer and an input of the current transformer;

Fig. 5 illustrates a block diagram of a sensing apparatus according to an embodiment of the present disclosure;

Fig. 6 illustrates a diagram of a circuit for implementing at least some parts of a sensing apparatus according to an embodiment of the present disclosure;

Fig. 7 illustrates a graph showing an output voltage of a current transformer and a graph showing a sensing signal for a secondary current of the current transformer according to an embodiment of the present disclosure;

Fig. 8 illustrates another graph showing an output voltage of a current transformer and another graph showing a sensing signal for a secondary current of the current transformer according to an embodiment of the present disclosure;

Fig. 9 illustrates a graph showing a primary current of a current transformer and a graph showing a secondary current of the current transformer according to an embodiment of the present disclosure;

Fig. 10 illustrates another graph showing a primary current of a current transformer and another graph showing a secondary current of the current transformer according to an embodiment of the present disclosure;

Fig. 11 illustrates experimental results for three current transformers according to an embodiment of the present disclosure;

Fig. 12 illustrates a fitting curve for a primary current and a secondary current of a current transformer according to an embodiment of the present disclosure;

Fig. 13 illustrates a perspective diagram of a sensing apparatus according to an embodiment of the present disclosure;

Fig. 14 illustrates a cross-sectional diagram of a contact arm according to an embodiment of the present disclosure; and

Fig. 15 illustrates a flow chart of a sensing method according to an embodiment of the present disclosure.

## DETAILED DESCRIPTION

The subject matter described herein will now be discussed with reference to several example embodiments. These embodiments are discussed only for the purpose of enabling those skilled persons in the art to better understand and thus implement the subject matter described herein, rather than suggesting any limitations on the scope of the subject matter.

The term "comprises" or "includes" and its variants are to be read as open terms that mean "includes, but is not limited to." The term "or" is to be read as "and/or" unless the context clearly indicates otherwise. The term "based on" is to be read as "based at least in part on." The term "one embodiment" and "an embodiment" are to be read as "at least one embodiment." The term "another embodiment" is to be read as "at least one other embodiment." Unless specified or limited otherwise, the terms "mounted," "connected," "supported," and "coupled" and variations thereof are used broadly and encompass direct and indirect mountings, connections, supports, and couplings. Furthermore, "connected" and "coupled" are not restricted to physical or mechanical connections or couplings. In the description below, like reference numerals and labels are used to describe the same, similar or corresponding parts in the Figures. Other explicit and implicit definitions may be included below.

In the existing solution of Patent Publication CN103854446B as mentioned above, the real-time current load is measured by another separate current sensor. This existing solution brings an additional cost for the separate current sensor and some additional work required for the separate current sensor, such as ratio setting and assembly for the separate current sensor. Since the current sensor is generally packed as a loose part, it is not easy for the customer to mount the current sensor in position, such as in a low-voltage compartment of the switchgear.

In order to at least partially solve the above and potentially other problems, embodiments of the present disclosure provide an improved solution for a new type of sensing, which integrates a temperature sensing and a primary current sensing together in order to enable a dynamic temperature algorithm with current monitoring by a single sensing module.

According to the embodiments of the present disclosure, a peak value for a secondary current of a current transformer serving as a power supply is detected during a saturation state of the current transformer in order to obtain a corresponding primary current of the current transformer, so that the primary current may be measured while monitoring a temperature by a temperature sensor powered by the current transformer. In this way, the primary current sensing is integrated with the existing temperature sensing without additionally configuring a current sensor. It makes great sense for providing a whole sensing solution for the temperature and the primary current without other loose sensors, and it brings the ease of assembly and use.

Hereinafter, the embodiments of the present disclosure will be described in detail with reference to the accompanying drawings.

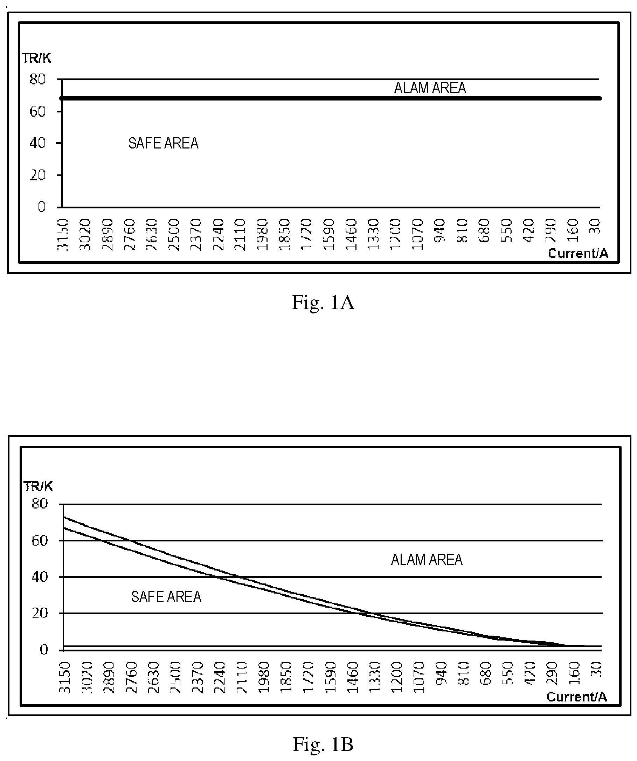

Fig. 1A illustrates a graph for monitoring a temperature of a contact arm without considering a current flowing through the contact arm. Fig. 1B illustrates a graph for monitoring a temperature of a contact arm while considering a current flowing through the contact arm. Fig. 1B shows the graph for the measuring the temperature as well as the primary current according to an embodiment of the present disclosure, and Fig. 1A shows the graph for the measuring only the temperature. In each of the graphs of Figs. 1A and 1B, the vertical axis represents the temperature value while the horizontal axis represents the primary current value, and a safe area and an alarm area for a working condition are depicted.

As shown in Fig. 1B by way of example, according to the embodiment of the present disclosure, the temperature value for the safe area increases as the primary current value increases. On the contrary, in the existing solution as shown in Fig. 1A, the temperature value for a safe area is constant regardless of the primary current value, which has a low reliability for monitoring. The embodiments of the present disclosure provide monitoring and diagnostic for the temperature by dynamically adjusting warning and alarm limit based on the real time current. Further, the embodiments of the present disclosure provide the sensing for both the real time current and the temperature by a sensing apparatus that integrates the primary current sensing with the existing temperature sensing. In this way, the monitoring for the working condition has an improved reliability without complicating design and assembly for the sensing apparatus.

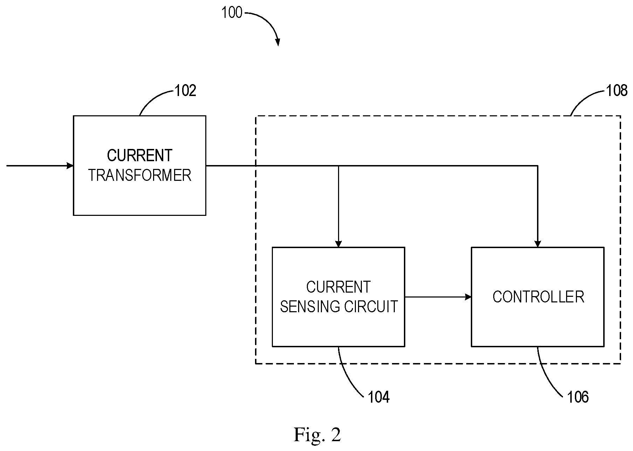

Fig. 2 illustrates a block diagram of a sensing apparatus 100 according to an embodiment of the present disclosure. As shown in Fig. 2, the sensing apparatus 100 comprises a current sensing circuit 104 and a controller 106. In some embodiments, the sensing apparatus 100 comprises a current transformer 102, a current sensing circuit 104, and a controller 106. In some embodiments, the current sensing circuit 104 and the controller 106 configure a sensing module 108.

The current transformer 102 is configured to receive a primary current from a bus bar to generate a secondary current. In some embodiments, the current transformer 102 serves as a power supply, and is configured for supplying a power to the sensing apparatus 100. In some embodiments, the current transformer 102 is configured to operate in its saturation state to provide enough energy for the sensing apparatus 100. In some embodiments, the current transformer 102 is configured to supply the power to the controller 106 to allow the controller 106 to work normally. In some embodiments, the current transformer 102 is further configured to supply the power to other components in the sensing apparatus 100, such as a temperature sensor for measuring the temperature and a communication module for communicating with an external device in a wireless or wired manner.

The current sensing circuit 104 is configured to sense the secondary current generated from the current transformer 102 to generate a secondary current signal representing the secondary current. In some embodiments, the current sensing circuit 104 comprises a resistor for sensing the secondary current to generate a voltage signal representing the secondary current.

The controller 106 is configured to detect a peak value for the secondary current and to measure the primary current based on the peak value for the secondary current. In some embodiments, the controller 106 is configured to detect the peak value of the secondary current signal representing the secondary current and generated from the current sensing circuit 104. In some embodiments, the controller 106 is configured to detect the peak value for the secondary current during a saturation of the current transformer 102, to measure the primary current. In some embodiments, the controller 106 is further configured to detect the peak value for the secondary current during a non-saturation of the current transformer 102, to measure the primary current.

The controller 106 is further configured to measure the primary current based on the peak value of the secondary current signal by a look-up table. In some embodiments, the controller 106 is configured to measure the primary current by searching the look-up table with the peak value of the secondary current signal. As such, during the non-saturation state and even the saturation state of the current transformer serving as the power supply, the primary current of the current transformer can be measured based on the peak value for the secondary current of the current transformer. In this way, the sensing apparatus 100 may integrate the primary current sensing with the existing temperature sensing.

The look-up table stores values of the primary current and respective peak values of the secondary current signal. In the look-up table, each of the peak values for the secondary current corresponds to the respective value of the primary current. In some embodiments, the values of the primary current are associated with the respective peak values of the secondary current signal by a fitting curve. The fitting curve may be represented by, e.g., an exponential function, a Fourier function, a Gauss function, a sine function, a power function, and/or a polynomial function. Other functions can be used as well. In this way, the correspondence relation between the primary current and the secondary current of the current transformer may be obtained to allow measuring the primary current while monitoring the temperature. Example embodiments of the fitting curve will be described in detail later.

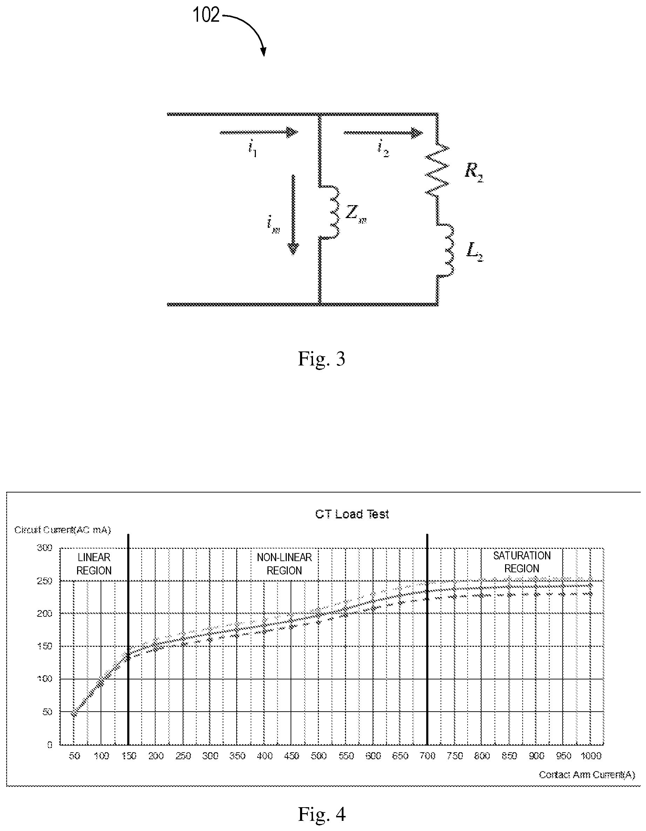

Fig. 3 illustrates an equivalent circuit diagram of the current transformer 102 according to some embodiments of the present disclosure. In some embodiments, the current transformer 102 is configured as a current transformer with iron core. Compared to Rogowski coils, the current transformer with iron core is very easy to saturate during measuring large currents, but the current transformer with iron core can provide enough energy for other circuit components of the sensing module to allow the circuit component to work normally. In some embodiments, an electromagnetic relationship between a primary side and a secondary side of the current transformer is established by an activation of a core magnetic field.

As shown in Fig. 3, based on the flux conservation and Kirchhoff current law, the following basic equations can be obtained by the equivalent circuit diagram of the current transformer:

$$\begin{cases} N_1(i_1 - i_m) = N_2 i_2 \\ N_2 \dfrac{d\phi}{dt} = R_2 i_2 + L_2 \dfrac{di_2}{dt} \\ \qquad f = f(i_m) \end{cases} \qquad (1)$$

where $i_1$ and $i_2$ represent the primary current and the secondary current, respectively; $i_m$ represents the excitation current through the core; $\phi$ represents a main magnetic flux; $N_1$ and $N_2$ represent winding turns of the primary side and the secondary side, respectively; $R_2$ represent a sum of a resistance of a secondary winding and an equivalent resistance of a secondary load, and $L_2$ represents a sum of a leakage inductance of the secondary winding and an inductance of the secondary load. In addition, ignoring the inductance of the iron core winding, $Z_m$ represents an excitation resistance.

According to the relationship between the main magnetic flux $\phi$ and the magnetic flux density B, the electromagnetic induction equation of the secondary winding can be obtained as follows:

$$N_2 A \frac{dB}{dt} = i_2 R_2 + L_2 \frac{di_2}{dt} \qquad (2)$$

where A represents an area for a cross-section of the core.

The full current equation of the core can be expressed by:

$$H l_m = N_1 i_1 - N_2 i_2 = N_1 i_m \quad (3)$$

where $l_m$ represents the inductance of the primary winding, and H represents the magnetic field strength.

The relationship between the magnetic flux density B, the magnetic field strength H and the magnetic permeability $\mu$ satisfies the following relationship:

$$B = \mu H \qquad\qquad (4)$$

Fig. 4 illustrates a graph showing a relationship between an output of the current transformer and an input of the current transformer. Fig. 4 shows a linear region, a transition region (or a non-linear region) and a saturation region, during which the curve represents different characteristics, respectively. In some embodiments, the secondary current of the current transformer is sensed to measure the primary current of the current transformer in a full current range by the curve as shown in Fig. 4.

During the magnetization of the core, the magnetic flux density B changes with the magnetic field strength $H(i_m)$, and the magnetization curve of the core is formed in the H-B plane. Under normal working conditions, the core magnetization curve is in the unsaturated region, and the magnetic permeability $\mu$ of the core is large. According to the equation (4), it is known that B changes significantly with the change of H. At this time, maintaining the variation of the core flux density requires only a small excitation current, ensuring that the primary side current flows substantially to the secondary side, so the current transformer can be regarded as an ideal transformer in the unsaturated region, and the primary current is linearly converted to the secondary current according to a transformation ratio of the secondary side to the primary side of the current transformer. When the current transformer according to some embodiments of the present disclosure operates in a linear state as indicated by this linear region of the curve, the peak value for the secondary current of the current transformer is detected to measure the primary current of the current transformer by the look-up table, in which the peak values of the secondary current are associated with the respective values of the primary current by the transformation ratio.

When the magnetization curve is located in the transition region or non-linear region, the magnetic permeability $\mu$ decreases significantly as the magnetic field strength H increases, and the output of the current transformer increases relatively slowly as the input of the current transformer increases. When the current transformer according to some embodiments of the present disclosure operates in a transition state as indicated by this transition region of the curve, the peak value for the secondary current of the current transformer is detected to measure the primary current of the current transformer by the look-up table, in which the peak values of the secondary current are associated with the respective values of the primary current by the fitting curve for the transition state as shown in Fig. 4.

When the current transformer is saturated, the magnetic permeability $\mu$ sharply decreases, and the magnetic flux density B hardly changes with the change of the magnetic field strength H. The excitation impedance $Z_m$ is almost one-tenth of the load impedance, and the excitation current $i_m$ of the current transformer core increases sharply, and the current flowing through the load is small or even zero. This causes the secondary current on the secondary side to be distorted, and the effective current for the secondary current is substantially constant. The current transformer operating in this saturation state generally serves as the power supply for other components, such as the temperature sensor, and the prior art does not utilize the current transformer of the saturation state to measure the primary current of the current transformer. The embodiments of the present disclosure provide a new solution for measuring the primary current of the current transformer by detecting the peak value for the secondary current of the current transformer during the saturation state by the fitting curve for the saturation state, the main principle of which will be described below.

When the primary current is reduced to zero by the direction of saturation of the current transformer and an inversion thereof is started, the magnetic flux density in the current transformer core is decreased by the saturation value, and then converted into the ideal transformer again, and the primary current are all converted to the secondary current by the ratio, until the secondary side is saturated again.

When the secondary side comprises a pure resistance load, the electromotive force at the secondary side can be expressed by:

$$e = i_1 R_2 / K \qquad (5)$$

where K represents the ratio of the secondary side to the primary side.

Under steady state conditions, the primary current at the primary side of the current transformer can be expressed by:

$$i_1 = I_{1max} \sin \omega t \qquad (6)$$

where $I_{1max}$ is the maximum value of the primary current, and $\omega$ is an angular frequency.

According to Faraday's law of electromagnetic induction, the following equation can be obtained:

$$e = n \frac{\Delta \Phi}{\Delta t} \qquad (7)$$

where n is the number of turns of the coil.

By moving n to the left of the equal sign and integrating both sides of the equal sign, the flowing equation can be obtained:

$$\Phi = \frac{1}{n} \int e dt \qquad (8)$$

Let the initial saturation flux be $\Phi_{sat}$, and the flux of the core will decrease from the initial saturation state at the same rate as during the saturation period, and the magnetic flux can be expressed by:

$$\Phi = \Phi_{sat} - \left(\frac{1}{N_2}\right) \int_0^t e dt = \Phi_{sat} - (I_{1max} R_2 / \omega N_2 K)(1 - \cos \omega t) \qquad (9)$$

According to the above change rule, if the unsaturation time of each half-wave core is $t_1$, the next half-wave saturation must also be at this time, and the value is substituted into the above equation (9) to obtain the following equation:

$$-\Phi_{sat} = \Phi_{sat} - (I_{1max} R_2 / \omega N_2 K)(1 - \cos \omega t_1) \qquad (10)$$

By a simple transformation for the equation (10), the following equation can be obtained:

$$\Phi_{sat} = (I_{1max} R_2 / 2 \omega N_2 K)(1 - \cos \omega t_1) \qquad (11)$$

The saturation flux is determined by inherent properties of the current transformer and is fixed, i.e., $R_2$, $\omega$, $N_2$, and K are fixed values. When the maximum value of the primary current $I_{1max}$ increases, according to the equation (11), during the interval of $0 \sim \pi/2$, i.e., during the current increases, $t_1$ decreases and thus the secondary current reaches the maximum value or peak value earlier. In the process of increasing the primary current, the maximum value or peak value of the secondary current at the saturation point will still increase, but the growth rate will gradually become smaller. In this case, as long as the curve of the change of the secondary current according to the primary current is measured, the primary current can be measured by a look-up table method, i.e., by a predefined relationship between the secondary current and the corresponding primary current.

According to the embodiments of the present disclosure, the measurement for the contact arm uses the power from the current transformer. The current transformer as the power supply has different output characteristics under different primary currents. With the characteristic of the saturation region for the current transformer, the secondary current can be measured, and the sensing apparatus for the contact arm is configured to have both the abilities to measure the temperature and measure the primary current. In this way, there is no need to configure an individual current sensor in addition to the temperature sensor.

Since the current transformer as the power supply has a saturated characteristic, after the primary current reaches above the saturation current, the output energy of the current transformer hardly increases. Therefore, the effective output current of the current transformer cannot be used to estimate the primary current. However, according to the equation (11), the larger the primary current is, the faster the saturation point of the current transformer reaches, that is, the faster the change rate of the primary current is, the faster the flux change rate becomes, and the larger the peak value of the secondary current becomes. Therefore, the primary current may by measured by detecting the peak value for the secondary current.

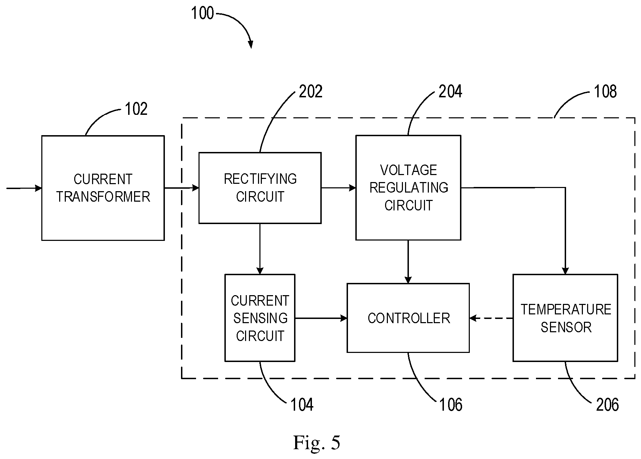

Fig. 5 illustrates a block diagram of the sensing apparatus 100 according to some embodiments of the present disclosure. Compared with those embodiments as shown in Fig. 2, the sensing apparatus 100 as shown in Fig. 5 further comprises a rectifying circuit 202, a voltage regulating circuit 204, and a temperature sensor 206. In some embodiments, the controller 106 may be comprised in the sensing module 108. In some embodiments, the sensing module 108 may comprise the rectifying circuit 202, the voltage regulating circuit 204, the temperature sensor 206, and/or the current sensing circuit 104.

The rectifying circuit 202 may be electrically coupled to the secondary side of the current transformer 102. The rectifying circuit 202 may be configured to rectify the secondary current to generate a rectified secondary current. In some embodiments, the rectifying circuit 202 comprises any known half-wave rectifying elements.

The voltage regulating circuit 204 may be electrically coupled to the rectifying circuit 202. The voltage regulating circuit 204 may be configured to generate a first regulated voltage based on the rectified secondary current to supply a first power to the temperature sensor 206. As such, the temperature sensor 206 is powered by the current transformer 102 and is supplied with the power from the voltage regulating circuit 204. In some embodiments, the voltage regulating circuit 204 is further configured to generate a second regulated voltage based on the rectified secondary current to supply a second power to the controller 106. As such, the controller 106 is powered by the current transformer 102 and is supplied with the power from the voltage regulating circuit 204.

The temperature sensor 206 may be electrically coupled to the voltage regulating circuit 204. The temperature sensor 206 may be configured to measure a temperature of its surroundings. In some embodiments, the temperature sensor 206 is mounted to a contact arm of the switchgear, and is configured to measure the temperature of the contact arm electrically coupled to the bus bar. In some embodiments, the temperature sensor 206 is electrically coupled to the controller 106 to transfer the sensed temperature signal to the controller 106. In some embodiments, the controller 106 calculates the real-time temperature based on the sensed temperature signal.

In some embodiments, the current sensing circuit 104 is electrically coupled to the rectifying circuit 202. The current sensing circuit 104 may be configured to sense the rectified secondary current to generate the secondary current signal. In some embodiments, the current sensing circuit 104 is configured to generate a voltage sensing signal for the secondary current.

In some embodiments, the controller 106 is electrically coupled to the current sensing circuit 104 and the voltage regulating circuit 204. The controller 106 may be configured to detect the peak value for the secondary current, and to measure the primary current based on the peak value for the secondary current.

In some embodiments, the sensing module 108 may further include a communication circuit electrically coupled to the processing unit 106, for communicating the measured current and/or temperature with the external device. In some embodiments, the communication circuit is also powered by the current transformer 102, and is supplied with a third power from the voltage regulating circuit 204. In this way, the operating parameters of the temperature and the current for the contact arm may be monitored by the controller 106 and/or the external device.

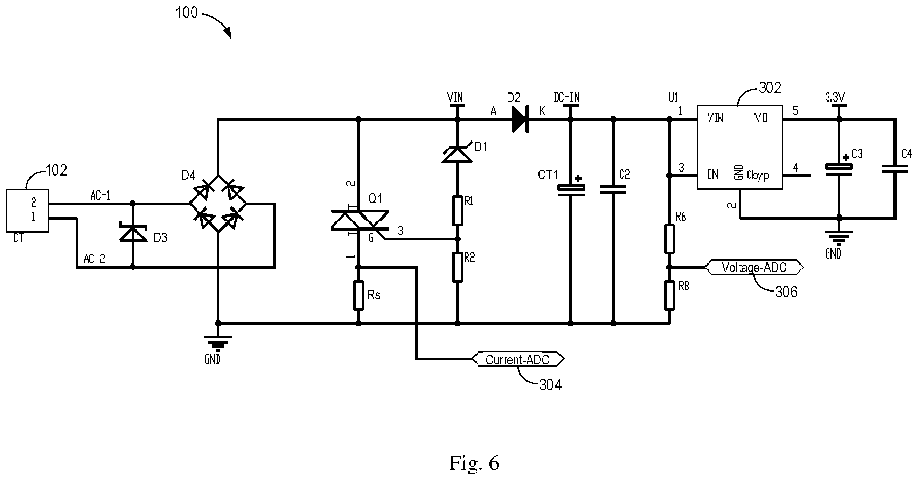

Fig. 6 illustrates a diagram of a circuit for implementing at least some parts of the sensing apparatus 100 according to some embodiments of the present disclosure. As shown in Fig. 6, in some embodiments, the sensing apparatus 100 comprises a full-bridge rectifying circuit coupled between a second output terminal and a first output terminal of the current transformer 102 and including four diodes D4 for rectifying the secondary current. The sensing apparatus 100 further comprises a diode D3 coupled between the first output terminal and the second output terminal of current transformer 102 for overvoltage protection. In some embodiments, the rectifying circuit 202 comprises the diode D3 and the full-bridge rectifying circuit including four diodes D4.

In some embodiments, the sensing apparatus 100 comprises a thyristor Q1 including a first terminal coupled to a resistor Rs and a second terminal coupled to the output of the full-bridge rectifying circuit. The resistor Rs is coupled between the thyristor Q1 and the ground.

After zero-crossing of the output voltage of the current transformer 102 during each positive or negative half wave, the thyristor Q1 and a Zener diode D1 are turned off. Then the output voltage of the current transformer 102 gradually increases. When the voltage at a terminal VIN coupled to the output terminal of the rectifying circuit is greater than the voltage at a terminal DC-IN, a capacitor CT1 coupled to the terminal DC-IN is charged through a diode D2 coupled between the terminal VIN and the terminal DC-IN, and the voltage at the terminal DC-IN is raised.

The output voltage of the current transformer continues to rise. When the voltage at the terminal VIN reaches a conduction voltage of the diode D1, the diode D1 is turned on. As a result, the thyristor Q1 is turned on, the diode D2 is turned off, and the output current of the current transformer 102 passes through the diodes D4, the thyristor Q1 and the resistor Rs to thereby form a loop. The resistor Rs is configured to sense the rectified secondary current to generate a voltage signal representing the rectified secondary current, and the voltage signal is delivered to the controller via a node 304 to detect the peak value for the secondary current.

In some embodiments, the current sensing circuit 104 comprises the resistor Rs. In some embodiments, the current sensing circuit 104 comprises the resistor Rs and the thyristor Q1. In other embodiments, the rectifying circuit 202 further comprises the thyristor Q1. In some embodiments, the rectifying circuit 202 further comprises the diode D1, the diode D2 and the capacitor CT1.

In some embodiments, the voltage regulating circuit 204 comprises a voltage regulator 302 coupled to the terminal DC-IN and is configured to output the regulated voltage. The voltage at the terminal DC-IN is sensed via a node 306. In Fig. 6, although the controller 106 and the temperature sensor 206 are not illustrated, the controller may be coupled to the node 304 to detect the peak value for the secondary current, and the temperature sensor 206 may be coupled to an output terminal 5 of the voltage regulator 302 so that the first power is supply to the temperature sensor 206. In some embodiments, the node 306 is coupled to the controller 106. In some embodiments, the voltage regulator 302 is further coupled to the controller 106 to supply the second power to the controller 106. Other components shown in Fig. 6 are configured for already known functions in the art, and the description thereof will be omitted herein.

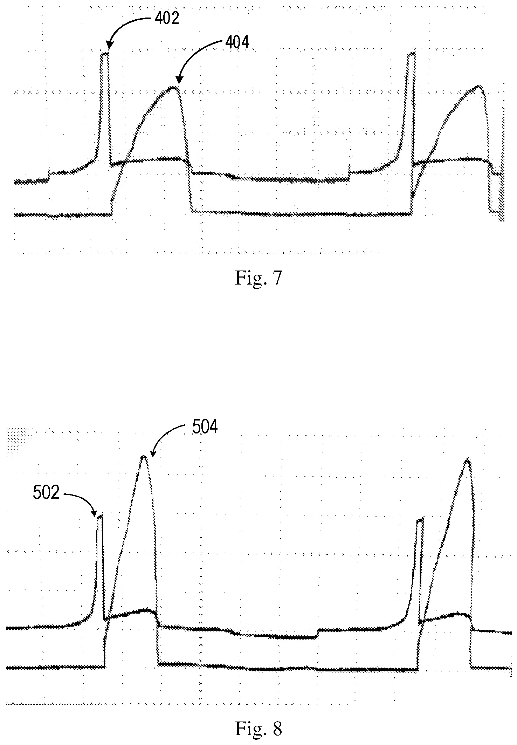

Fig. 7 illustrates a graph 402 showing an output voltage of a current transformer and a graph 404 showing a sensing signal for a secondary current of the current transformer according to some embodiments of the present disclosure. Fig. 8 illustrates another graph 502 showing an output voltage of a current transformer and another graph 504 showing a sensing signal for a secondary current of the current transformer according to some embodiments of the present disclosure. The sensing signal for the secondary current is the voltage across the resistor Rs as shown in Fig. 6.

In Fig. 7, Graph 404 shows the sensing signal of the voltage across the resistor Rs at a smaller primary current; while Graph 504 in Fig. 8 shows the sensing signal of the voltage across the resistor Rs at a larger primary current. Graph 402 and Graph 502 indicate the output voltage of the current transformer. As can be seen from Figs. 7 and 8, when the primary current increases, the pulse width of the sensing signal for the secondary current becomes narrower, the peak value of the sensing signal for the secondary current becomes larger, and the overall area (i.e., effective value) does not change much, which is consistent with the saturation characteristic of the current transformer. As long as the controller 106 quickly samples and scans the peak or maximum value of the voltage across the resistor Rs within a few cycles, the peak value for the secondary current from the current transformer 102 can be obtained.

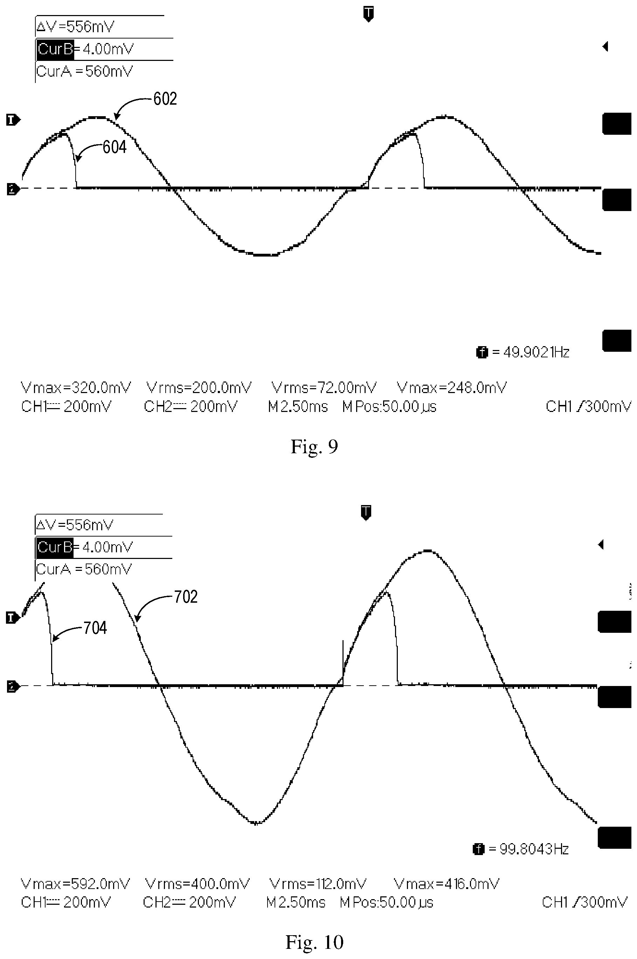

Fig. 9 illustrates a graph 602 showing a primary current of a current transformer and a graph 604 showing a secondary current of the current transformer according to some embodiments of the present disclosure. Fig. 10 illustrates another graph 702 showing a primary current of a current transformer and another graph 704 showing a secondary current of the current transformer according to some embodiments of the present disclosure. It can be clearly seen from Figs. 9 and 10 that the secondary current of the current transformer is distorted and cut off during the ascending process.

Graph 604 in Fig. 9 shows a secondary current at a smaller primary current as shown by Graph 602, while Graph 704 in Fig. 10 shows a secondary current at a larger primary current as shown by Graph 702. As can be seen from Figs. 9 and 10, when the primary current increases, the pulse width of the secondary current becomes narrower, and the peak value for the secondary current becomes larger. Comparing Figs. 9 and 10, when the RMS of the primary current is relatively small, the secondary current waveform is turned on for about 3 ms and has a smaller peak value, and when the RMS of the primary current is relatively large, the secondary current waveform is turned on for about 2.5 ms and has a larger peak value, which also verifies the above principle.

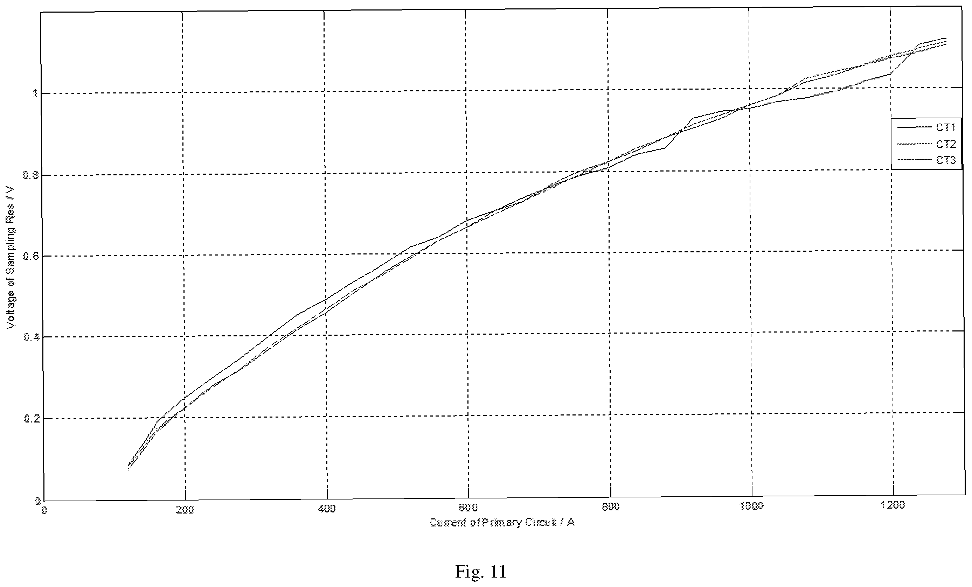

Fig. 11 illustrates experimental results for three current transformers according to some embodiments of the present disclosure. In Fig. 11, the vertical axis represents the voltage sensing signal for the secondary current while the horizontal axis represents the value for the primary current.

Three current transformers as the power supply were taken in the experiment and applied to the above circuit as shown in Fig. 6. Three curves for the experimental results of the three current transformers are obtained. The primary current starts from 120A and rises to 1280A, and each step is incremented by 40A. The voltage across the resistor Rs is sensed to obtain the curves in Fig. 11. The three curves do not overlap in some places, but basically can reflect the magnitude of the primary current. It is sufficient for the evaluation of "dynamic current-temperature rise". If a higher accuracy is required, methods of segmentation calibration and approximate straight line can also be adopted.

When the primary current is too small to cause the thyristor to be turned on, the voltage across the resistor Rs is always 0. At this time, the controller 106 can monitor the voltage at the terminal DC-IN via the node 306 as shown in Fig. 6 to evaluate the magnitude of the primary current, because the current transformer characteristic is linear and the primary current can be calculated directly from the secondary current at this time.

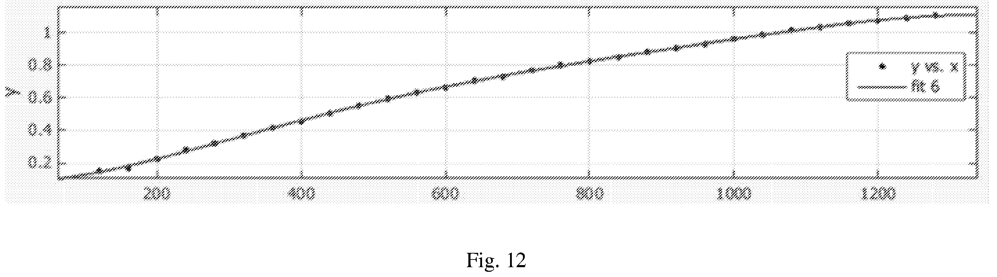

Fig. 12 illustrates a fitting curve for a primary current and a secondary current according to some embodiments of the present disclosure. The above experimental results as shown in Fig. 11 are discrete points. To put the experiments into the practical measurement application, it is necessary to sort out a curve through a large number of experiments, and then obtain a curve formula by a curve fitting to get data needed for the look-up table. In some embodiments, the curve fitting toolbox in Matlab is utilized to complete the fitting work and to obtain the fitting curve. The values of the primary current are associated with the respective peak values of the secondary current signal in the look-up table by the fitting curve. The fitting curve as shown in Fig. 12 may be represented by at least one of an exponential function, a Fourier function, a Gauss function, a sine function, a power function, or a polynomial function. In some embodiments, the fitting curve may be represented by a fifth-order polynomial function.

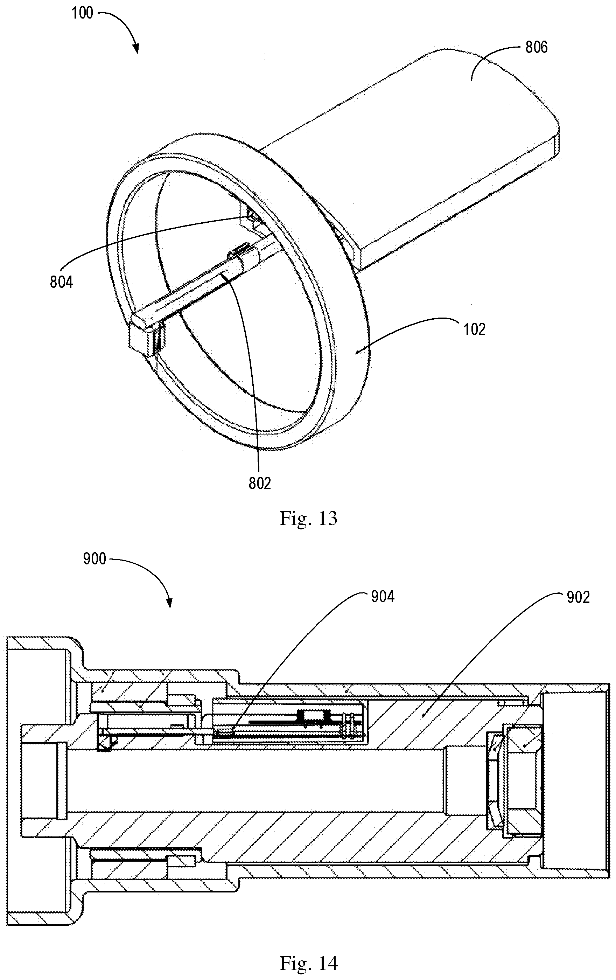

Fig. 13 illustrates a perspective diagram of the sensing apparatus 100 according to some embodiments of the present disclosure. As shown in Fig. 13, in some embodiments, the sensing apparatus 100 comprises a circuit board 804 and a housing 806 for the circuit board 804. In some embodiments, the current transformer 102 is external to the sensing apparatus 100. In other embodiments, the sensing apparatus 100 comprises the current transformer 102, a signal line 802, the circuit board 804, and the housing 806. The signal line 802 is configured to electrically couple the current transformer 102 to the circuit board 804.

In some embodiments, at least some components of the sensing module 108 as shown in Figs. 2 and 5 are mounted on the circuit board 804. In some embodiments, the current sensing circuit 104 and the controller 106 of the sensing apparatus 100 are mounted on the circuit board 804. In other embodiments, the current sensing circuit 104, the controller 106, the rectifying circuit 202 and the voltage regulating circuit 204 are mounted on the circuit board 804.

Fig. 14 illustrates a cross-sectional diagram of a smart arm 900 according to some embodiments of the present disclosure. As shown in Fig. 14, the smart arm 900 comprises a contact arm 902 and a sensing module 904. In some embodiments, the smart arm 900 is configured as an integrated sensing apparatus for the switchgear.

The contact arm 902 is configured to be electrically coupled to the bus bar. In some embodiments, the contact arm 902 is placed in a circuit breaker of the switchgear.

In some embodiments, the smart arm 900 comprises the sensing module 904 embedded within the contact arm 902. Alternatively, in other embodiments, the smart arm 900 comprises the sensing module 904 mounted onto an outer surface of the contact arm 902.

In some embodiments, the smart arm 900 comprises the current transformer 102 and the sensing module 108 described with reference to Figs. 2 and 5. In some embodiments, the sensing module 904 comprises at least some components of the sensing apparatus 100. In some embodiments, the sensing module 904 comprises at least some components of the sensing module 108. In some embodiments, the sensing module 904 comprises the circuit board 804. In some embodiments, the current transformer 102 is electrically coupled to the contact arm 902.

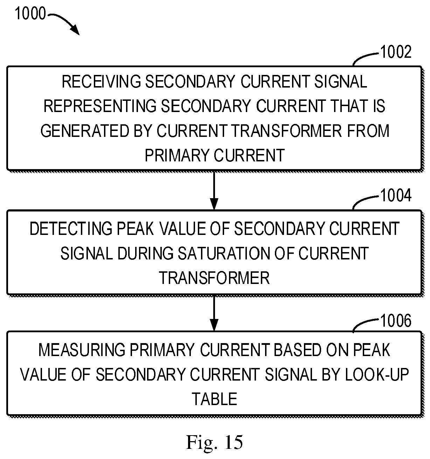

Fig. 15 illustrates a flow chart of a sensing method according to some embodiments of the present disclosure. As shown in Fig. 15, the flow chart of the sensing method 1000 comprises blocks 1002 to 1006. In some embodiments, the sensing method 1000 may be performed by the controller 106.

At block 1002, the sensing method 1000 comprises receiving the secondary current signal representing the secondary current that is generated by the current transformer from the primary current. In some embodiments, the current transformer is configured to receive the primary current from a bus bar and to generate the secondary current signal for supplying a power. In some embodiments, receiving the secondary current signal comprises receiving the secondary current signal that is generated by sensing the secondary current of the current transformer. In some embodiments, the secondary current signal is a voltage sensing signal across a resistor for the secondary current.

At block 1004, the sensing method 1000 comprises detecting a peak value of the secondary current signal during a saturation of the current transformer. In some embodiments, detecting the peak value comprises sampling and scanning the peak or maximum value of the secondary current signal within a few cycles to determine the peak value of the secondary current signal.

At block 1006, the sensing method 1000 comprises measuring the primary current based on the peak value of the secondary current signal by a look-up table. In some embodiments, measuring the primary current comprises measuring the primary current by searching the look-up table with the peak value of the secondary current signal, the look-up table storing values of the primary current and respective peak values of the secondary current signal. In some embodiments, the values of the primary current are associated with the respective peak values of the secondary current signal by the fitting curve. In some embodiments, the fitting curve is obtained by pre-experiments on the correspondence relationship between the primary current and the secondary current for one or more current transformers. In some embodiments, the fitting curve is represented by at least one of an exponential function, a Fourier function, a Gauss function, a sine function, a power function, or a polynomial function.

According to the embodiments of the present disclosure, the primary current sensing is integrated with the temperature sensing by measuring the peak value for the secondary current of the current transformer, which serves as the power supply for the temperature sensing, even during its saturation state, thereby obtaining the corresponding value of the primary current. In this way, the primary current sensing and the temperature sensing can be implemented by a single sensing module without an additional current sensor, thereby simplifying the structure of the sensing module and facilitating the assembly for the sensing module.

The invention is defined by the appended claims.

**Claims**

1. A sensing apparatus (100), comprising:

a current sensing circuit (104) configured to sense a secondary current generated from a current transformer (102) to generate a secondary current signal representing the secondary current, the current transformer (102) configured to receive a primary current from a bus bar to generate the secondary current for supplying a power to the sensing apparatus (100); and

a controller (106) configured to detect a peak value of the secondary current signal during a saturation of the current transformer (102), and configured to measure the primary current based on the peak value of the secondary current signal by a look-up table.

2. The sensing apparatus (100) of claim 1, wherein the controller (106) is configured to measure the primary current by searching the look-up table with the peak value of the secondary current signal, the look-up table storing values of the primary current and respective peak values of the secondary current signal.

3. The sensing apparatus (100) of claim 2, wherein the values of the primary current are associated with the respective peak values of the secondary current signal by a fitting curve.

4. The sensing apparatus (100) of claim 3, wherein the fitting curve is represented by at least one of the following: an exponential function, a Fourier function, a Gauss function, a sine function, a power function, or a polynomial function.

5. The sensing apparatus (100) of claim 1, further comprising:
a temperature sensor (206) configured to measure a temperature.

6. The sensing apparatus (100) of claim 5, wherein:

(a) the temperature sensor (206) is configured to measure the temperature of a contact arm of a switchgear electrically coupled to the bus bar; or
(b) the temperature sensor (206) is supplied with the power.

7. The sensing apparatus (100) of claim 5, further comprising:

a rectifying circuit (202) configured to rectify the secondary current to generate a rectified secondary current; and
a voltage regulating circuit (204) configured to generate a first regulated voltage based on the rectified secondary current to supply a first power to the temperature sensor (206).

8. The sensing apparatus (100) of claim 7, wherein:

(a) the voltage regulating circuit (204) is further configured to generate a second regulated voltage based on the rectified secondary current to supply a second power to the controller (106); or
(b) the current sensing circuit (104) is configured to sense the rectified secondary current to generate the secondary current signal.

9. The sensing apparatus (100) of any of claims 1 to 8, further comprising:

(a) the current transformer (102); and/or
(b) a circuit board (804) on which the current sensing circuit (104) and the controller (106) are mounted; and a signal line (802) electrically coupling the circuit board (404) to the current transformer (102).

10. The sensing apparatus (100) of any of claims 7 and 8, further comprising:

a circuit board (804) on which the current sensing circuit (104), the controller (106), the rectifying circuit (202) and the voltage regulating circuit (204) are mounted; and
a signal line (802) electrically coupling the circuit board (404) to the current transformer (102).

11. A smart arm (900) for a switchgear, comprising:

a contact arm (902) configured to be electrically coupled to a bus bar; and
the sensing apparatus (100) of any of claims 1 to 10.

12. The smart arm (900) of claim 11, wherein the sensing apparatus (100) is embedded within the contact arm (902) or mounted onto an outer surface of the contact arm (902).

13. The smart arm (900) of claim 11 or 12, wherein the current transformer (102) is electrically coupled to the contact arm (902).

14. A sensing method, comprising:

receiving a secondary current signal representing a secondary current that is generated by a current transformer from a primary current;
detecting a peak value of the secondary current signal during a saturation of the current transformer; and
measuring the primary current based on the peak value of the secondary current signal by a look-up table.

15. The sensing method of claim 14, wherein measuring the primary current comprises:

measuring the primary current by searching the look-up table with the peak value of the secondary current signal, the look-up table storing values of the primary current and respective peak values of the secondary current signal, wherein preferably the values of the primary current are associated with the respective peak values of the secondary current signal by a fitting curve,
wherein more preferably the fitting curve is represented by at least one of the following: an exponential function, a Fourier function, a Gauss function, a sine function, a power function, or a polynomial function.

**Patentansprüche**

1. Erfassungsvorrichtung (100), umfassend:

eine Stromerfassungsschaltung (104), die so konfiguriert ist, dass sie einen von einem Stromwandler (102) erzeugten Sekundärstrom erfasst, um ein den Sekundärstrom darstellendes Sekundärstromsignal zu erzeugen, wobei der Stromwandler (102) so konfiguriert ist, dass er einen Primärstrom von einer Sammelschiene empfängt, um den Sekundärstrom zur Versorgung der Erfassungsvorrichtung (100) mit Strom zu erzeugen; und
eine Steuereinrichtung (106), die so konfiguriert ist, dass sie einen Spitzenwert des Sekundärstromsignals während einer Sättigung des Stromwandlers (102) detektiert, und den Primärstrom auf der Grundlage des Spitzenwerts des Sekundärstromsignals anhand einer Nachschlagetabelle misst.

2. Erfassungsvorrichtung (100) nach Anspruch 1, wobei die Steuereinheit (106) so konfiguriert ist, dass sie den Primärstrom durch Durchsuchen der Nachschlagetabelle mit dem Spitzenwert des Sekundärstromsignals misst, wobei die Nachschlagetabelle Werte des Primärstroms und jeweilige Spitzenwerte des Sekundärstromsignals speichert.

3. Erfassungsvorrichtung (100) nach Anspruch 2, wobei die Werte des Primärstroms durch eine Anpassungskurve mit den jeweiligen Spitzenwerten des Sekundärstromsignals verknüpft sind.

4. Erfassungsvorrichtung (100) nach Anspruch 3, wobei die Anpassungskurve durch mindestens eine der folgenden Funktionen dargestellt wird: eine Exponentialfunktion, eine Fourier-Funktion, eine Gauß-Funktion, eine Sinusfunktion, eine Potenzfunktion oder eine Polynomfunktion.

5. Erfassungsvorrichtung (100) nach Anspruch 1, ferner umfassend:
einen Temperatursensor (206), der so konfiguriert ist, dass er eine Temperatur misst.

6. Erfassungsvorrichtung (100) nach Anspruch 5, wobei:

(a) der Temperatursensor (206) so konfiguriert ist, dass er die Temperatur eines Kontaktarms einer elektrisch mit der Sammelschiene gekoppelten Schaltanlage misst; oder
(b) der Temperatursensor (206) mit Strom versorgt wird.

7. Erfassungsvorrichtung (100) nach Anspruch 5, ferner umfassend:

eine Gleichrichtungsschaltung (202), die so konfiguriert ist, dass sie den Sekundärstrom gleichrichtet, um einen gleichgerichteten Sekundärstrom zu erzeugen; und
eine Spannungsregelungsschaltung (204), die so konfiguriert ist, dass sie auf der Grundlage des gleichgerichteten Sekundärstroms eine erste geregelte Spannung erzeugt, um den Temperatursensor (206) mit einer ersten Leistung zu versorgen.

8. Erfassungsvorrichtung (100) nach Anspruch 7, wobei:

   (a) die Spannungsregelungsschaltung (204) ferner so konfiguriert ist, dass sie auf der Grundlage des gleichgerichteten Sekundärstroms eine zweite geregelte Spannung erzeugt, um eine zweite Leistung an die Steuereinheit (106) zu liefern; oder
   (b) die Stromerfassungsschaltung (104) so konfiguriert ist, dass sie den gleichgerichteten Sekundärstrom erfasst, um das Sekundärstromsignal zu erzeugen.

9. Erfassungsvorrichtung (100) nach einem der Ansprüche 1 bis 8, ferner umfassend:

   (a) den Stromwandler (102); und/oder
   (b) eine Leiterplatte (804), auf der die Stromerfassungsschaltung (104) und die Steuereinheit (106) angebracht sind; und eine Signalleitung (802), die die Leiterplatte (404) elektrisch mit dem Stromwandler (102) verbindet.

10. Erfassungsvorrichtung (100) nach einem der Ansprüche 7 und 8, ferner umfassend:

    eine Leiterplatte (804), auf der die Stromerfassungsschaltung (104), die Steuereinheit (106), die Gleichrichterschaltung (202) und die Spannungsregelungsschaltung (204) angebracht sind; und
    eine Signalleitung (802), die die Leiterplatte (404) elektrisch mit dem Stromwandler (102) verbindet.

11. Intelligenter Arm (900) für eine Schaltanlage, umfassend:

    einen Kontaktarm (902), der so konfiguriert ist, dass er elektrisch mit einer Sammelschiene gekoppelt werden kann; und
    die Erfassungsvorrichtung (100) aus einem der Ansprüche 1 bis 10.

12. Intelligenter Arm (900) nach Anspruch 11, wobei die Erfassungsvorrichtung (100) in den Kontaktarm (902) eingebettet oder an einer Außenfläche des Kontaktarms (902) angebracht ist.

13. Intelligenter Arm (900) nach Anspruch 11 oder 12, wobei der Stromwandler (102) elektrisch mit dem Kontaktarm (902) gekoppelt ist.

14. Messverfahren, umfassend:

    Empfangen eines Sekundärstromsignals, das einen Sekundärstrom darstellt, der von einem Stromwandler aus einem Primärstrom erzeugt wird;
    Erfassen eines Spitzenwerts des Sekundärstromsignals während einer Sättigung des Stromwandlers; und
    Messen des Primärstroms auf der Grundlage des Spitzenwerts des Sekundärstromsignals anhand einer Nachschlagetabelle.

15. Messverfahren nach Anspruch 14, wobei das Messen des Primärstroms umfasst:

    Messen des Primärstroms durch Durchsuchen der Nachschlagetabelle mit dem Spitzenwert des Sekundärstromsignals, wobei die Nachschlagetabelle Werte des Primärstroms und jeweilige Spitzenwerte des Sekundärstromsignals speichert,
    wobei vorzugsweise die Werte des Primärstroms mit den jeweiligen Spitzenwerten des Sekundärstromsignals durch eine Anpassungskurve verknüpft sind,
    wobei die Anpassungskurve vorzugsweise durch mindestens eines von Folgenden dargestellt wird:
    eine Exponentialfunktion, eine Fourier-Funktion, eine Gauß-Funktion, eine Sinusfunktion, eine Potenzfunktion oder eine Polynomfunktion.

**Revendications**

1. Appareil de détection (100), comprenant :

   un circuit de détection de courant (104) configuré pour détecter un courant secondaire généré par un transformateur de courant (102) afin de générer un signal de courant secondaire représentant le courant secondaire, le transformateur de courant (102) étant configuré pour recevoir un courant primaire d'une barre omnibus afin de générer le courant secondaire permettant de fournir une puissance à l'appareil de détection (100) ; et
   un contrôleur (106) configuré pour détecter une valeur de crête du signal de courant secondaire pendant une saturation du transformateur de courant (102), et configuré pour mesurer le courant primaire sur la base de la valeur de crête du signal de courant secondaire au moyen d'une table de correspondance.

2. Appareil de détection (100) selon la revendication 1, dans lequel le contrôleur (106) est configuré pour mesurer le courant primaire en consultant la table de correspondance à l'aide de la valeur de crête du signal de courant secondaire, la table de correspondance stockant des valeurs du courant primaire et des valeurs de crête respectives du signal de courant secondaire.

3. Appareil de détection (100) selon la revendication 2, dans lequel les valeurs du courant primaire sont associées aux valeurs de crête respectives du signal de courant secondaire par une courbe d'ajustement.

4. Appareil de détection (100) selon la revendication 3, dans lequel la courbe d'ajustement est représentée par au moins l'une des fonctions suivantes : une fonction exponentielle, une fonction de Fourier, une fonction gaussienne, une fonction sinusoïdale, une fonction puissance, ou une fonction polynomiale.

5. Appareil de détection (100) selon la revendication 1, comprenant en outre :
   un capteur de température (206) configuré pour mesurer une température.

6. Appareil de détection (100) selon la revendication 5, dans lequel :

   (a) le capteur de température (206) est configuré pour mesurer la température d'un bras de contact d'un appareillage de commutation couplé électriquement à la barre omnibus ; ou
   (b) le capteur de température (206) absorbe la puissance.

7. Appareil de détection (100) selon la revendication 5, comprenant en outre :

   un circuit redresseur (202) configuré pour redresser le courant secondaire afin de générer un courant secondaire redressé ; et
   un circuit de régulation de tension (204) configuré pour générer une première tension régulée sur la base du courant secondaire redressé afin de fournir une première puissance au capteur de température (206).

8. Appareil de détection (100) selon la revendication 7, dans lequel :

   (a) le circuit de régulation de tension (204) est configuré en outre pour générer une deuxième tension régulée sur la base du courant secondaire redressé afin de fournir une deuxième puissance au contrôleur (106) ; ou
   (b) le circuit de détection de courant (104) est configuré pour détecter le courant secondaire redressé afin de générer le signal de courant secondaire.

9. Appareil de détection (100) selon l'une quelconque des revendications 1 à 8, comprenant en outre :

   a) le transformateur de courant (102) ; et/ou
   (b) une carte de circuit imprimé (804) sur laquelle sont montés le circuit de détection de courant (104) et le contrôleur (106) ; et une ligne de signal (802) couplant électriquement la carte de circuit imprimé (404) au transformateur de courant (102).

10. Appareil de détection (100) selon l'une quelconque des revendications 7 et 8, comprenant en outre :

    une carte de circuit imprimé (804) sur laquelle sont montés le circuit de détection de courant (104), le contrôleur (106), le circuit redresseur (202) et le circuit de régulation de tension (204) ; et

une ligne de signal (802) couplant électriquement la carte de circuit imprimé (404) au transformateur de courant (102).

11. Bras intelligent (900) pour un appareillage de commutation, comprenant :

un bras de contact (902) configuré pour être couplé électriquement à une barre omnibus ; et
l'appareil de détection (100) selon l'une quelconque des revendications 1 à 10.

12. Bras intelligent (900) selon la revendication 11, dans lequel l'appareil de détection (100) est incorporé dans le bras de contact (902) ou monté sur une surface extérieure du bras de contact (902).

13. Bras intelligent (900) selon la revendication 11 ou 12, dans lequel le transformateur de courant (102) est couplé électriquement au bras de contact (902).

14. Procédé de détection, comprenant :

la réception d'un signal de courant secondaire représentant un courant secondaire généré par un transformateur de courant à partir d'un courant primaire ;
la détection d'une valeur de crête du signal de courant secondaire pendant une saturation du transformateur de courant ; et
la mesure du courant primaire sur la base de la valeur de crête du signal de courant secondaire au moyen d'une table de correspondance.

15. Procédé de détection selon la revendication 14, dans lequel la mesure du courant primaire comprend :

la mesure du courant primaire par consultation de la table de correspondance à l'aide de la valeur de crête du signal de courant secondaire, la table de correspondance stockant des valeurs du courant primaire et des valeurs de crête respectives du signal de courant secondaire,
dans lequel, de préférence, les valeurs du courant primaire sont associées aux valeurs de crête respectives du signal de courant secondaire par une courbe d'ajustement.
dans lequel, de préférence encore, la courbe d'ajustement est représentée par au moins l'une des fonctions suivantes : une fonction exponentielle, une fonction de Fourier, une fonction gaussienne, une fonction sinusoïdale, une fonction puissance, ou une fonction polynomiale.

Fig. 1A

Fig. 1B

100

102

CURRENT
TRANSFORMER

108

CURRENT
SENSING CIRCUIT

CONTROLLER

104

106

Fig. 2

102

Fig. 3

Fig. 4

Fig. 5

Fig. 6

Fig. 7

Fig. 8

ΔV=556mV

CurB= 4.00mV

CurA =560mV

602

604

= 49.9021Hz

Vmax=320.0mV   Vrms=200.0mV   Vrms=72.00mV   Vmax=248.0mV
CH1= 200mV   CH2= 200mV   M2.50ms   MPos:50.00μs   CH1 ∕300mV

Fig. 9

ΔV=556mV

CurB= 4.00mV

CurA =560mV

702

704

= 99.8043Hz

Vmax=592.0mV   Vrms=400.0mV   Vrms=112.0mV   Vmax=416.0mV
CH1= 200mV   CH2= 200mV   M2.50ms   MPos:50.00μs   CH1 ∕300mV

Fig. 10

Fig. 11

EP 3 997 465 B1

Fig. 12

Fig. 13

Fig. 14

1000

1002

RECEIVING SECONDARY CURRENT SIGNAL
REPRESENTING SECONDARY CURRENT THAT IS
GENERATED BY CURRENT TRANSFORMER FROM
PRIMARY CURRENT

1004

DETECTING PEAK VALUE OF SECONDARY CURRENT
SIGNAL DURING SATURATION OF CURRENT
TRANSFORMER

1006

MEASURING PRIMARY CURRENT BASED ON PEAK
VALUE OF SECONDARY CURRENT SIGNAL BY LOOK-UP
TABLE

Fig. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008008446 A2
- US 6040689 A
- CN 203405292 U
- CN 103854446 B